Europäisches Patentamt

European Patent Office

Office européen des brevets

(11) Publication number: **0 076 935**
**B1**

(12) **EUROPEAN PATENT SPECIFICATION**

(45) Date of publication of patent specification: **19.07.89**

(21) Application number: **82108570.1**

(22) Date of filing: **17.09.82**

(51) Int. Cl.⁴: **H 01 L 27/16** // G01F1/68

(54) **Integrated semiconductor device and method of fabricating said device.**

(30) Priority: **09.10.81 US 310345**
**09.10.81 US 310262**
**09.10.81 US 310263**
**09.10.81 US 310261**
**09.10.81 US 310344**
**09.10.81 US 310264**

(43) Date of publication of application:
**20.04.83 Bulletin 83/16**

(45) Publication of the grant of the patent:
**19.07.89 Bulletin 89/29**

(84) Designated Contracting States:
**DE FR GB NL**

(56) References cited:
**EP-A-0 019 135**
**EP-A-0 021 225**
**EP-A-0 021 291**
**DE-A-2 658 273**
**FR-A-2 219 406**
**FR-A-2 356 932**
**GB-A-2 029 583**
**IEEE SPECTRUM, vol. 18, no. 9, September 1981, pages 33-39, New York, US; P.W. BARTH: "Silicon sensors meet integrated circuits"**

(73) Proprietor: **HONEYWELL INC.**
**Honeywell Plaza**
**Minneapolis Minnesota 55408 (US)**

(72) Inventor: **Bonne, Ulrich**
**4936 Shady Oak Road**
**Hopkins Minnesota 55343 (US)**
Inventor: **Higashi, Robert E.**
**810 S.E. 8th Street, Apt. 20**
**Minneapolis Minnesota 55414 (US)**
Inventor: **Johnson, Robert G.**
**12814 March Circle**
**Minnetonka Minnesota 55343 (US)**
Inventor: **Sumner, John P.**
**7101 Heatherton Trail**
**Edina Minnesota 55434 (US)**

(74) Representative: **Rentzsch, Heinz et al**
**Honeywell Europe S.A. Holding KG Patent- und Lizenzabteilung Kaiserleistrasse 55**
**D-6050 Offenbach am Main (DE)**

Courier Press, Leamington Spa, England.

## Description

The present invention relates to an integrated semiconductor device according to the preamble of claim 1 and to a method of fabricating it. Such devices are needed in the field of sensors and radiant sources of electromagnetic energy.

From IEEE Spectrum, Vol. 18, No. 9, September 1981, pgs. 33 to 39, such a semiconductor device is known where a depression is formed within a semiconductor body and sensor means or part of such means, respectively, are suspended over said depression.

Departing from this known device, it is the object of the present invention to improve the thermal and physical isolation of the sensor means from the chip and to reduce the manufacturing time of the device. This object is achieved by the characterizing features of claim 1. Further advantageous embodiments of the inventive device as well as a method of fabricating it may be taken from the subclaims and claim 32, respectively.

The present invention has applications in areas including flow sensing, detection of combustible gases, humidity sensing and pressure sensing. However, the present invention is not limited to such applications.

With respect to the figures of the attached drawings, embodiments of the inventive device as well as a method of fabricating it shall be described where

Figs. 1—3 are cross-sectional drawings of preferred embodiments in accordance with the present invention;

Figure 4 illustrates an electrically resistive grid compatible with the present invention.

Figure 5 illustrates circuitry compatible with some preferred embodiments of the present sensor;

Figures 6—8 illustrates a sensor in accordance with the present invention;

Figure 9 illustrates a combustible gas sensor in accordance with the present invention;

Figures 10—13 illustrate orientation and alternate preferred embodiments of microstructure detail in accordance with the present invention.

As previously indicated, the present invention has applications in areas such as flow sensing, detection of combustible gases, humidity sensing, and pressure sensing. These specific applications will be discussed below, followed by discussions of generic devices and processing steps associated with fabrication of the present structures.

### Flow sensor

Thermal anemometry has been for many years a useful tool for the measurement of fluid flow. Thermal anemometers, by definition, depend upon heat transfer for their operation. A resistor with a temperature sensitive resistance is typically placed in the flow stream. Electric current flowing through the resistor causes the resistor to increase in temperature due to electrical power dissipation. The fluid being monitored carries heat away from the resistor via forced convection. The ultimate temperature of the resistor, as indicated by measured resistance, is a function of the fluid's velocity and thermal conductivity. Prior art transducing resistive elements are typically of the hot-wire, hot-film, thermistor type.

The ideal thermal anemometer would be inexpensive yet posssess a very fast response resistor/transducer and be accurate and rugged. These requirements are often conflicting, as evidenced by state-of-the-art thermal anemometers. Cheap anemometers are typically comprised of bulky sensing elements which cause a poor response time characteristic. Fast responding anemometers are typically expensive and have fragile sensing elements. Accurate anemometers are typically expensive due to labor intensive assembly of the sensing element and support structure. Moreover, state-of-the-art aneomometers must be fully inserted into the fluid flow region and, consequently, are subject to destruction or deterioration by impacting dust, lint, or other debris.

The present thermal anemometer or flow transducer more closely provides all the features desired in an ideal transducer. The disclosed device is inexpensive, as it can be fabricated by low cost batch processes such as silicon-compatible processes; the device responds with a thermal time constant in the millisecond range; and the accuracy of the device exceeds those of prior solid state thermal anemometers due to an increased sensitivity (greater change in resistance for a given change in flow) and signal to noise ratio. Moreover, its design is such that it need not be fully inserted into the fluid stream. As a result, dust, lint, and debris tend to flow by the sensing element rather than impacting it. The present anemometer is therefore less subject to performance deterioration than state-of-the-art thermal anemometers.

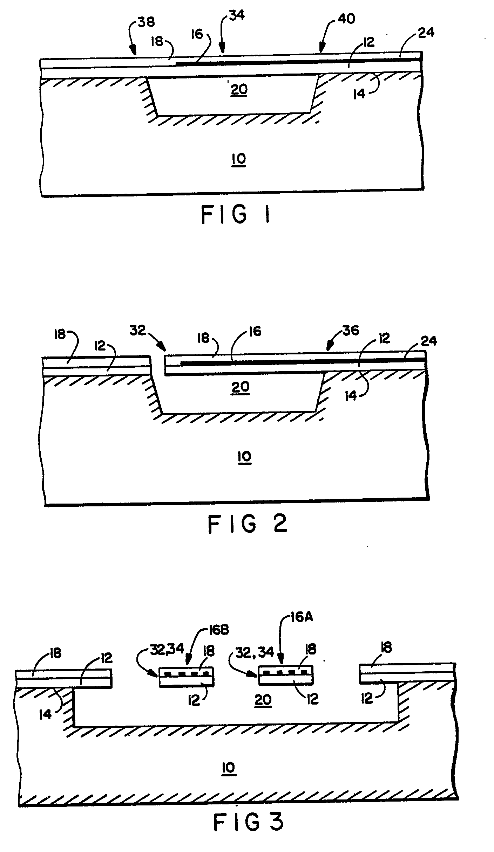

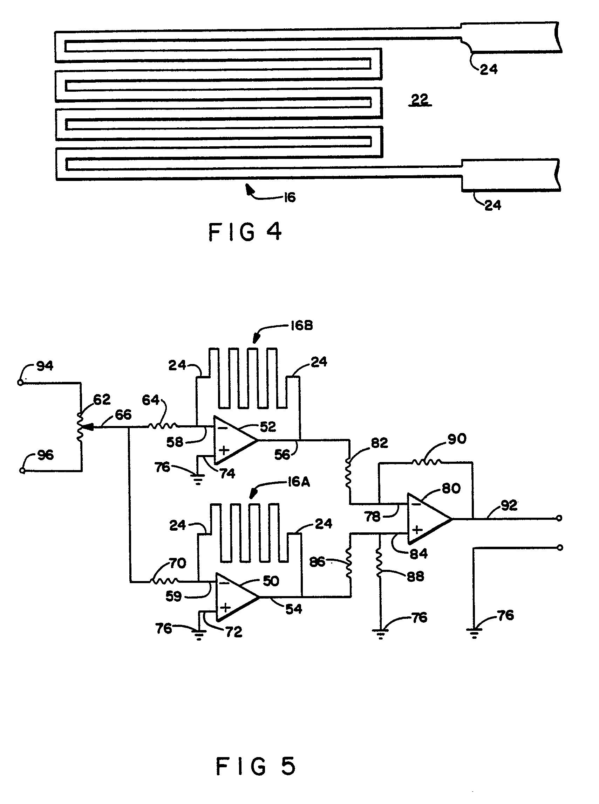

Figures 1 and 2 are cross-sectional side views of alternate preferred embodiments of flow sensors in accordance with the present invention. A mono-crystalline semiconductor 10 has a first surface 14 covered with a dielectric layer 12 such as silicon nitride. In the embodiment shown, an element 22 (Figure 4) comprises a permalloy resistive element or grid 16 and leads 24 sputtered onto dielectric layer 12, element 22 being covered with a layer 18 of dielectric such as silicon nitride.

Dielectric layer 12 provides electrical isolation between element 22 and semiconductor 10 (layers 12 and 18 also provide passivation for element 22). Substantial thermal and physical isolation is provided between resistive element 16 and semiconductor 10 by forming a depression 20 below element 16. Depression 20 is formed using etching techniques such as those discussed elsewhere herein. Without depression 20, it would be difficult to achieve substantial thermal and physical isolation between sensing element 16 and semiconductor 10; for example, if resistive element 16 were separated from semiconductor 10 by only a solid dielectric layer, resistive element 16 would be substantially heat-sunk into semiconductor 10 since the thermal conductivities of solid dielectrics are typically much greater than the thermal conductivity of air.

Substantial thermal and physical isolation between sensing element 16 and semiconductor 10 provides many advantages adaptable to a wide variety of devices such as sensors. For example, in the case of the present semiconductor body flow sensor, by providing a very thin sensing means that is substantially thermally isolated from the semiconductor body, the sensing means is adapted to provide a very sensitive measurement of air flow, since the temperature of the thin structure will be readily affected by the air flow. This is in contrast to solid state thermal anemometers that have sensing elements substantially heat sunk into the semiconductor body; the temperature sensitivity of such structures is greatly affected by the thermal mass of the semiconductor itself.

In the embodiment of Figure 1, member or sensing means 34 is bridged across depression 20, member means 34 having first and second ends 38 and 40 connected to semiconductor first surface 14. As disclosed, member means 34 is substantially rectangular in shape when viewed from above, member means 34 as disclosed comprising resistive element 16 and a portion of dielectric layers 12 and 18.

In the embodiment of Figure 2, member or sensing means 32, comprising a resistive element 16 and a portion of dielectric layers 12 and 18, is cantilevered over depression 20, only one end 36 of member means 32 being connected to semiconductor first surface 14. Having only one end of member means 32 connected to semiconductor body 10 provides certain advantages, including the advantage of permitting member means 32 to expand and contract in substantially all directions without substantial restraint from semiconductor body 10. In addition, member means 32 provides an embodiment having substantially increased thermal isolation because heat loss by conduction through member means 32 occurs through only one supporting end.

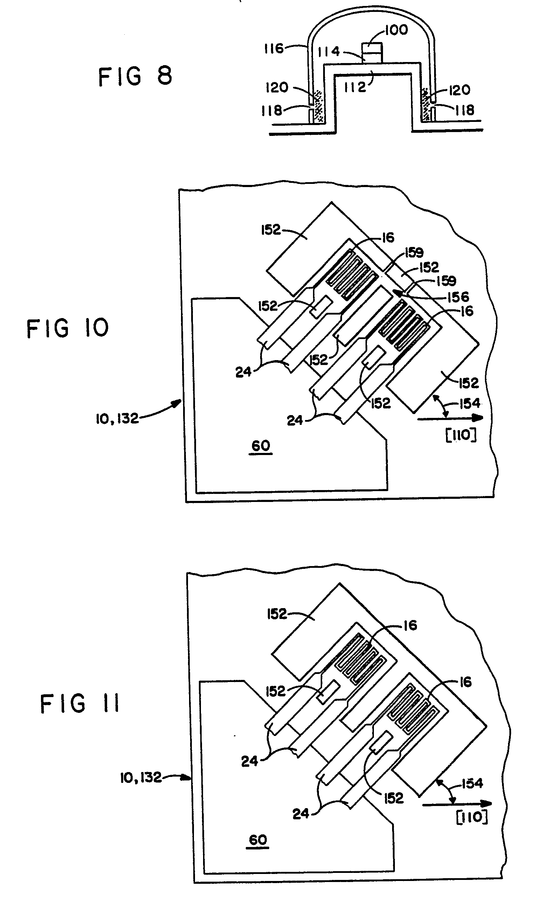

Figure 3 illustrates an end cross-sectional view of a preferred embodiment comprising two member means 32 or 34 (Figures 10—13 illustrate top views of various alternate preferred embodiments). With regard to the present flow sensor, a pair of member means is a preferred embodiment having certain advantages. For example, as is further discussed below, using two substantially identical member means and offsetting a signal from one against a signal from the other can provide automatic temperature compensation for changing environmental temperatures. In addition, such an arrangement can greatly increase measurement accuracy, since background voltage within a single sensor can easily be substantially eliminated. Further, using two measurement elements in a flow sensor provides an indication of flow direction as well as rate, since the upstream element cools more than the downstream element, as is further explained below.

However, a single sensing means supported over depression 20 is consistent with the present flow sensor; for example, for making a flow/no-flow measurement, an air turbulence signal generated in a single-sensing-element flow sensor would be adequate to establish the presence or the absence of air flow. Amplification of only the a.c. (turbulent flow) component of the element resistance change eliminates detection of slow or d.c. changes in element resistance caused, for example, by changing environmental temperature.

For the preferred embodiments shown, permalloy was selected to form resistive element 16 because permalloy can be precisely deposited by sputtering a layer only tenths of nanometers (hundreds of angstroms) thick, and because the characteristics of permalloy provide a highly sensitive predetermined relationship between the resistance of grid or element 16 and the temperature of the element. For example, a very thin member or sensing means 32 or 34 may be formed of resistive element 16 and dielectric layers 12 and 18. When applied as a flow sensor, air flowing over member means 32 or 34 will cause resistive element 16 to cool in predetermined relation to the rate of air flow, thus causing a change in resistance and providing a measurement of the air flow.

For the embodiments shown, member means 32 and 34 are typically on the order of 0.8—1.2 μm thick, this thickness including element 16 (typically on the order of 80 nm (800 angstroms) thick) and dielectric layers 12 and 18, each typically on the order of hundreds of nanometers (thousands of angstroms) thick. This very thin and highly sensitive configuration, in combination with the fact that sensing element 16 is substantially isolated from the body of the semiconductor 10 by depression 20 (typically in the range of 0,025 to 0,25 mm deep) causes the sensing means to be highly sensitive to flow measurements.

As previously indicated, a preferred embodiment of element 16 comprises a permalloy grid as shown in Figure 4. Leads 24 may be permalloy since additional processing steps are then avoided (making leads 24 of another material would require additional processing steps; although leads 24 of permalloy become slightly heated, they are relatively wide, as illustrated in Figures 4 and 10—13, and they are substantially heat sunk into semiconductor body 10, making heating of leads 24 relatively minor).

As previously indicated, advantages exist in providing a flow transducer comprising first and second resistive elements such as illustrated in Figure 3. Such an embodiment may be coupled with a circuit such as illustrated in Figure 5, thus providing a flow transducer which is independent of environmental temperatures and which provides further sensitivity by eliminating background signals and directly providing a measurement signal.

For the purpose of discussing the operation of the sensor embodiment illustrated in Figure 3 and for the purpose of describing the circuit illustrated in Figure 5, the sensing elements in these figures have been labeled 16A and 16B, each element 16A and 16B comprising an element 16. Elements 16A and 16B are typically matched (at least substantially identical), but they do not have to be matched.

A substantial advantage of the present invention is that circuits such as illustrated in Figure 5 may be integrated directly onto semiconductor body 10, thus providing a complete sensing system on a single chip through batch processing.

The circuit illustrated in Figure 5 comprises three differential amplifiers, each of which may comprise, for example, a TLO87. As illustrated, each of two amplifiers 50 and 52 have a resistive element 16A or 16B connected across its feedback loop. Thus, resistive element 16A is connected between an output 54 and a negative input 59 of amplifier 50, the connections being made via leads 24 associated with element 16A. Resistive element 16B is connected across an output 56 and a negative input 58 of amplifier 52, the connections again being made with leads 24 associated with element 16B.

Negative input 58 to amplifier 52 is connected to a wiper 66 of a potentiometer 62 through a resistor 64. Negative input 59 to amplifier 50 is connected to wiper 66 through a resistor 70. Positive inputs 72 and 74 of amplifiers 50 and 52 respectively are connected to ground or reference potential 76.

Output 56 of amplifier 52 is connected to a negative input 78 of amplifier 80 through a resistor 82, output 54 of amplifier 50 being connected to a positive input 84 to amplifier 80 through a resistor 86. Positive input 84 of amplifier 80 is also connected to ground or reference potential 76 through a resistor 88. A resistor 90 is connected between an output 92 of amplifier 80 and negative input 78 of the amplifier.

A first terminal 94 of potentiometer 62 is provided for connection to a positive power supply such as +15VDC, a second terminal 96 of potentiometer 62 being provided for connection to a negative power supply such as −15VDC. Potentiometer 62 provides a means for selecting a predetermined voltage anywhere between the plus and minus voltage of the power supply.

In operation, the disclosed circuit generates a voltage between output 92 and ground or reference potential 76 that bears a predetermined relationship to gas flow rate over member means 32 or 34 comprising resistive elements 16A and 16B.

Resistive elements 16A and 16B are configured into the feedback loops of amplifiers 50 and 52, respectively. Each operational amplifier 50 and 52 maintains constant current through its feedback loop. Therefore, the electrical current flowing through each resistive element 16A and 16B is independent of the element resistance. In order to maintain constant current in its feedback loop, each operational amplifier in effect changes its output voltage in proportion to the change in resistance of resistive elements 16A or 16B. As previously indicated, the resistance of each permalloy element 16A or 16B changes in a predetermined manner with the temperature of the resistive element. Therefore, the voltage output of each operational amplifier 50 and 52 bears a predetermined relationship to the associated resistive element temperature.

Operational amplifier 80 amplifies the difference between the voltage outputs of operational amplifiers 50 and 52, the voltage at output 92 being proportional to the difference in voltage between the output voltages of operational amplifiers 50 and 52. Accordingly, the voltage at output 92 bears a predetermined relationship to the temperature difference between resistive elements 16A and 16B. The temperature difference between resistive elements 16A and 16B bears a predetermined relationship to the gas flow rate over the elements. Therefore, the voltage at output 92 of amplifier 80 bears a predetermined relationship to the rate of flow across elements 16A and 16B.

Gas flowing first over one member or sensing means comprising resistive element 16A and then over a second member or sensing means comprising element 16B causes resistive element 16A to cool more than resistive element 16B, since the gas flowing over element 16A picks up heat from element 16A and carries heat to the vicinity of element 16B. Assuming that the circuit supply voltage at wiper 66 is positive, this causes the output voltage of amplifier 52 to be greater than the output voltage of amplifier 50. This difference is magnified by amplifier 80, the output voltage at output 92 bearing a predetermined relationship to the rate of gas flow. As previously indicated, the output voltage at output 92 can also provide an indication of directionality. For example, if elements 16A and 16B are aligned along the flow in a duct, the present two-element sensor can be used to determine direction of flow as well as flow rate, since the upstream element will cool more than the downstream element, as explained above.

As indicated, the circuit illustrated in Figure 5 operates sensing elements 16A and 16B in a constant current mode. It should be noted that other circuits are also possible including circuits which would operate sensors 16A and 16B (or any of the present sensors) in a constant voltage mode, a constant temperature (constant resistance) mode, or a constant power mode.

Humidity sensor

The present invention also has applications as a humidity sensor. In such applications, the present sensor can measure atmospheric water vapor concentration or relative humidity independently of surface adsorption effects and independently of optical effects and does this at very low cost on a semiconductor chip compatible with signal processing integration.

The present humidity sensor depends upon the variation of thermal conductivity of air as the water vapor concentration varies. Water vapor concentration here is defined as the ratio of the number of water vapor molecules per unit volume to the number of molecules of dry air per unit volume. This concentration is sometimes referred to as molal humidity which is related to specific humidity by the constant ratio of the molecular weight of water to the average molecular weight of dry air.

Accordingly, the present humidity sensor provides a direct indication of molal humidity which may be converted to specific humidity through a circuit (not shown) providing an appropriate multiplier to the molal humidity measurement.

It may also be of interest to convert molal humidity measurements to measurements of relative humidity. Such a conversion requires a measurement of ambient temperature and requires that a corresponding automatic adjustment be made according to standard psychrometric chart data. An appreciable altitude effect caused by air mixture density variation is also involved in a conversion to relative humidity because, for any given mole fraction of water vapor measured by thermal conductivity, the partial pressure of the water vapor will vary with altitude. Consequently, for the most accurate relative humidity measurement, the conversion must be adjusted slightly by an altitude-dependent factor. Such conversions may be made by circuitry (not shown).

Environmental control applications may require a device readout in terms of air mixture enthalpy referred to the enthalpy at some lower reference temperature and zero humidity. Enthalpy varies linearly with temperature at constant molal humidity and linearly with molal humidity at constant temperature in ranges of interest that exclude freezing and condensation. Therefore, an enthalpy determination can be obtained from a molal humidity measurement and the air mixture temperature by a circuit (not shown) that yields a readout offset for dry air proportional to the difference between mixture temperature and reference temperature, and which calibrates the molal humidity output to an enthalpy scale.

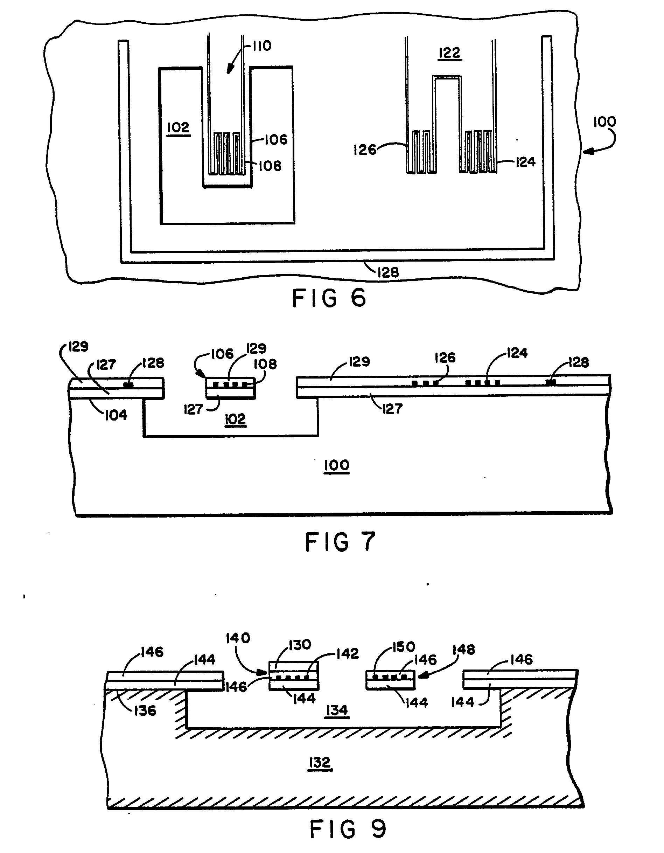

In its simplest form, the present humidity sensor comprises a semiconductor body 100 (Fig. 7) having a depression 102 etched into a first surface 104 of the body. The present humidity sensor further comprises member means such as 106 which may be either bridged across depression 102 in the manner of member means 34 shown in Figure 1, or may be of a cantilever configuration as shown in Figures 2 and 6. Member means 106 typically comprises a resistive element such as 108, member means 106 having a predetermined configuration suspended over the depression, the member means being connected to first surface 104 at least at one location such as location 110. Depression 102 opens to first surface 104 around at least a portion of the predetermined configuration of member means 106.

Resistive element 108, when provided with current, becomes heated, there being a predetermined relationship between the resistance and the temperature of resistive element 108.

The present humidity sensor further comprises no-flow means 116, Figure 8, for substantially preventing air flow over member means 106, thus substantially preventing cooling of resistive element 108 due to air flow. The no-flow means permits the humidity level to equalize between member means 106 and semiconductor body 100 with the humidity level in the surrounding environment, the no-flow means example 116 containing apertures 118 for this purpose. Also shown are filters 120 to prevent the present sensor from becoming contaminated by air-borne particulates.

Resistive element 108 is adapted to provide a signal having a magnitude related to the resistance and, therefore, the temperature of element 108, the magnitude of the signal varying with humidity due to varying thermal coupling between element 108 and semiconductor body 100 through depression 102, the varying thermal coupling arising through the varying conductivity of air with varying molal humidity, the signal thus providing a measurement of humidity.

In a typical application of the present humidity sensor, semiconductor body or chip 100 is mounted with epoxy to a glass member 114, which in turn is mounted to a header 112. The glass member substantially thermally isolates substrate 100 from the header. The header typically comprises feedthroughs (not shown) in order to connect a wire bonded structure for making electrical connections.

The present humidity sensor may also comprise reference resistor means 122 comprising a resistive element 124. As further discussed below, the present humidity sensor may further comprise series resistor means 126 having a substantially zero thermal coefficient of resistance (TCR) over a predetermined temperature range of interest. As shown in Figure 6 and explained below, series resistor means 126 may be connected in series with resistive element 124; alternately, series resistor means 126 may be connected in series with resistive element 108. As examples, series resistor means 126 may comprise a chrome silicide or a nichrome element.

The present humidity sensor may further comprise heater means comprising an element 128 for controlling the temperature of semiconductor body 100 to a predetermined temperature. Element 128 may comprise a resistive element such as a permalloy element substantially heat sunk to the semiconductor body.

Like resistive element 108, resistive element 124 may comprise a permalloy grid not unlike that shown in Figure 4. As such, element 124 may serve not only as a reference resistor for element 108 but also as a temperature measuring sensor for element 124 and/or for thermostated semiconductor body 100, the permalloy having a predetermined relationship between temperature and resistance. Thus, semiconductor body 100 can be maintained at a predetermined elevated temperature by regulating current through resistive element 128 and monitoring the temperature of body 100 with element 124.

As disclosed, elements 108, 124, 126, and 128 are sandwiched between two layers of dielectric such as silicon nitride, a first layer 127 also covering at least a portion of first surface 104, and a second layer 129.

With a permalloy element 124 substantially heat sunk to semiconductor body 100, the temperature of element 124 is substantially regulated by the temperature of the semiconductor body. Further, since element 124 is substantially thermally coupled to semiconductor body 100, the resistance of element 124 does not substantially vary with varying humidity. Accordingly, a signal from element 124 may be offset by a signal from element 108, thus effectively providing a resulting signal that under predetermined conditions of specific humidity will have a predetermined value. A circuit substantially as shown in Figure 5 may be used to attain such a result, elements 16A and 16B of Figure 5 being replaced with elements 108 and 124 of the humidity sensor, and element 126 being put in series with either element 108 or 124 as appropriate.

The temperature versus resistance curves of permalloy elements are nonlinear. Thus, the temperature versus resistance curve of element 108 will have a first predetermined slope when operating at a first predetermined operating temperature. The resistance of element 124 may then be established so that, at a second predetermined temperature, e.g., typically the thermostated temperature of chip or body 100 as measured by element 124, the temperature versus resistance curve of element 124 has a slope substantially equal to the first predetermined slope of element 108 at its operating temperature. The total effective resistance of element 108 or 124, as appropriate, may then be adjusted by adding series resistor means 126 in series with either element 108 (this arrangement is not shown) or 124 (as shown), series resistor means 126 having a substantially zero thermal coefficient of resistance over the temperature range of interest. As a result, the total effective resistance of the reference element may be made to be substantially equal at the second predetermined temperature to the total effective resistance of the humidity sensing element at the first predetermined temperature. In this manner, when the effective resistance of the reference and humidity sensing elements are substantially equal, signals through the two elements may be offset so that at a predetermined humidity the sum of the signals will be substantially zero.

Again, this can be accomplished with a circuit substantially as that shown in Figure 5.

Combustible gas sensor

As previously indicated, the present invention also has applications as a sensor for detecting combustible gas. The present combustible gas sensor as disclosed in Figure 9 is quite similar to the flow sensor as disclosed in Figure 3 except that a reactive means 130 is thermally coupled to one of the resistive elements. When heated in the presence of a combustible gas and oxygen, reactive means 130 provides an indication of the presence of a combustible gas. In addition, a no-flow means such as no flow means 116 used with the present humidity sensor is also used to substantially prevent air flow over the first and second member means of the embodiment shown.

In Figure 9, reactive means 130 is shown thermally coupled to resistive element 142 within member means 140. In one preferred embodiment of the present combustible gas sensor, reactive means 130 typically comprises a catalytically reactive thin film of, for example, iron oxide, platinum, or palladium which is heated by resistive element 142. In such an embodiment, the catalytically reactive thin film, when heated in the presence of a combustible gas and oxygen, causes an exothermic reaction which changes the temperature and, accordingly, the resistance of its corresponding resistive element 142. Thus, the change in temperature of resistive element 142 due to the exothermic reaction provides a change in the resistance of the element indicating the presence of a combustible gas.

In an alternate preferred embodiment of the present combustible gas sensor, reactive means 130 may comprise a metal oxide resistive element of, for example, iron oxide or tin oxide which is heated by resistive element 142 (the metal oxide resistive element may be configured similar to element 16 shown in Figure 4). In such an embodiment, the metal oxide resistive element changes in resistance when heated by resistive element 142 in the presence of a combustible gas and oxygen, thus indicating the presence of a combustible gas.

More specifically, the present sensor for detecting combustible gas comprises a semiconductor body 132 having a depression 134 etched into a first surface 136 of the semiconductor body or chip 132.

The present sensor further comprises member means 140 which may be either bridged across depression 134 in the manner of member means 34 shown in Figure 1, or may be of cantilever configuration such as member means 32 shown in Figure 2. The member means typically comprises a resistive element such as 142 which may comprise a permalloy grid such as shown in Figure 4. Member means 140 has a predetermined configuration suspended over depression 134, member means 140 being connected to first surface 136 at least at one location. Depression 134 opens to first surface 136 around at least a portion of the predetermined configuration of member means 140. Member means 140 provides substantial physical and thermal isolation between element 142 and semiconductor body 132. As previously indicated, member means 140 further comprises reaction means 130 thermally coupled to resistive element 142.

Resistive element 142 when provided with current becomes heated, there being a predetermined relationship between the resistance and the temperature of resistive element 142.

As also previously indicated, the present combustible gas sensor also employs no-flow means such as no-flow means 116 shown in Figure 8, the no-flow means substantially preventing air flow over member means 140, thus substantially preventing cooling of resistive element 142 due to air flow. The no-flow means permits access of combustible gas to reactive means 130 by, for example, apertures such as 118 shown in Figure 8.

As previously indicated, in a first preferred embodiment of the present combustible gas sensor, reactive means 130 typically comprises a catalytically reactive thin film. In such an embodiment, reactive means 130 when heated by resistive element 142 in the presence of a combustible gas and oxygen causes an exothermic reaction, thus causing a change in temperature and, accordingly, resistance of resistive element 142. This change in resistance of resistive element 142 indicates the presence of a combustible gas. In a second preferred embodiment, reactive means 130 typically comprises a metal oxide resistive element. In such an embodiment, resistive element changes resistance when heated by resistive element 142 in the presence of a combustible gas and oxygen, thus indicating the presence of a combustible gas.

As disclosed resistive element 142 is encapsulated in two layers of dielectric such as silicon nitride, a first layer 144 also covering at least a portion of first surface 136, and a second layer 146. As shown, reactive means 130 is deposited above dielectric layer 146 on member means 140.

If the first preferred embodiment of the present combustible gas sensor is used, it may be desirable to employ a second resistive element 150 embodied in a second member means 148. As disclosed, a second member means 148 has a predetermined configuration suspended over depression 134, second member means 148 being connected to first surface 136 at least at one location, depression 132 opening at first surface 136 around at least a portion of the predetermined configuration of member means 148. Depression 132 provides substantial physical and thermal isolation between second resistive element 148 and semiconductor body 132.

Except that member means 148 is without reactive means such as 130, member means 140 and 148 may be substantially identical. Members means 148 including its resistive element 150 may then be used as a reference element having substantially the same reaction to changes in ambient temperature as member means 140, thus providing automatic temperature compensation. Further, the signal from reference element 150 may be offset against the signal from sensing element 142, thus substantially eliminating background signal levels and obtaining a direct measurement of the signal caused by the change in temperature introduced by reactive means 130. Substantially the same circuit as shown in Figure 5 may be used to accomplish this, elements 142 and 150 replacing elements 16A and 16B shown in the Figure.

Pressure sensor

The present invention also has applications as a pressure sensor, typically as a sensor for measuring sub-atmospheric pressures. A need exists for a pressure sensor covering a relatively wide dynamic range. For example, general industrial processes employing various gases such as oxygen, argon, nitrogen, and hydrogen at varying temperatures and pressures frequently require the measurement of pressure as part of process control

Conventional tungsten-heated thermal conductivity pressure sensors in the sub-atmospheric pressure range are unsatisfactory because of a relatively low dynamic range, high power and voltage requirements, fragility, relatively low sensitivity (because of low thermal coefficient of resistance) and low life (tungsten readily oxidizes when the oxygen partial pressure increases faster than cooling time constant of the heated tungsten). The present pressure sensor eliminates or reduces the severity of these shortcomings.

The present pressure sensor depends upon the variation of thermal conductance of a gas volume. More specifically, as mean free path lengths become limited by the distance between a member means such as 106 and a semiconductor substrate such as 100 below it, thermal conductivity and heat removal rate from the member means decreases with decreasing gas pressure. This leads to a temperature increase of a resistive element such as 108 in the member means, assuming that the resistive element is being operated with a constant current.

The present pressure sensor may be constructed substantially like the present humidity sensor, and the same Figures as used to describe the present humidity sensor will also be used to decribe the present pressure sensor.

In its simplest form, the present pressure sensor comprises a semiconductor body 100 having a depression 102 etched into a first surface 104 of the body. The present pressure sensor further comprises member means such as 106 which may be either bridged across depression 102 in the manner of member means 34 shown in Figure 1, or may be of a cantilever configuration as shown in Figures 2 and 6. Member means 106 typically comprises a resistive element 108, member means 106 having a predetermined configuration suspended over the depression, the member means being connected to first surface 104 at least at one location such as location 110. Depression 102 opens to first surface 104 around at least a portion of the predetermined configuration of member means 106.

Resistive element 108, when provided with current, becomes heated, there being a predetermined relationship between the resistance and the temperature of resistive element 108.

The present pressure sensor further comprises no-flow means 116, Figure 8, for substantially preventing air flow over member means 106, thus substantially preventing cooling of resistive element 108 due to air flow. The no-flow means permits the pressure level to equalize between member means 106 and semiconductor body 100 with the pressure level in the surrounding environment, the no-flow means example 116 containing apertures 118 for this purpose. Also shown are filters 120 to prevent the present sensor from becoming contaminated by air-borne particulates.

Resistive element 108 is adapted to provide a signal having a magnitude related to the resistance and, therefore, the temperature of element 108, the magnitude of the signal varying with sub-atmospheric pressure due to varying thermal coupling between element 108 and semiconductor body 100 through depression 102, the varying thermal coupling arising through the varying conductivity of air with varying pressure, the signal thus providing a measurement of pressure.

In a typical application of the present pressure sensor, semiconductor body or chip 100 is mounted with epoxy to a glass member 114, which in turn is mounted to a header 112. The glass member substantially thermally isolates substrate 100 from the header. The header typically comprises feed throughs (not shown) in order to connect a wire bonded structure for making electrical connections.

The present pressure sensor may also comprise reference resistor means 122 comprising a resistive element 124. As was discussed in association with the present humidity sensor, the present pressure sensor may further comprise series resistor means 126 having a substantially zero thermal coefficient of resistance (TCR) over a predetermined temperature range of interest. As shown in Figure 7, series resistor means 126 may be connected in series with resistive element 124; alternately, series resistor means 126 may be connected in series with resistive element 108. As examples, series resistor means 126 may comprise a chrome silicide or a nichrome element.

The present pressure sensor may further comprise heater means comprising an element 128 for controlling the temperature of semiconductor body 100 to a predetermined temperature. Element 128 may comprise a resistive element such as a permalloy element substantially heat sunk to the semiconductor body.

Like resistive element 108, resistive element 124 may comprise a permalloy grid not unlike that shown in Figure 4. As such, element 124 may serve not only as a reference resistor for element 108 but also as a temperature measuring sensor for element 124 and/or for thermostated semiconductor body 100, the permalloy having a predetermined relationship between temperature and resistance. Thus semiconductor body 100 can be maintained at a predetermined elevated temperature by regulating current through resistive element 128 and monitoring the temperature of body 100 with element 124.

As disclosed, elements 108, 124, 126, and 128 are sandwiched between two layers of dielectric such as silicon nitride, a first layer 127 also covering at least a portion of first surface 104, and a second layer 129.

With a permalloy element 124 substantially heat sunk to semiconductor body 100, the temperature of element 124 is substantially regulated by the temperature of the semiconductor body. Further, since element 124 is substantially thermally coupled to semiconductor body 100, the resistance of element 124 does not substantially vary with varying pressure. Accordingly, a signal from element 124 may be offset by a signal from element 108, thus effectively providing a resulting signal that under predetermined conditions of pressure will have a predetermined value. A circuit substantially as shown in Figure 5 may be used to obtain such a result, elements 16A and 16B of Figure 5 being replaced with elements 108 and 124 of the present pressure sensor, and element 126 being put in series with either element 108 or 124 as appropriate.

The temperature versus resistance curve of permalloy elements are nonlinear. Thus, the temperature versus resistance curve of element 108 will have a first predetermined slope when operating at a first predetermined operating temperature. The resistance of element 124 may then be established so that, at a second predetermined temperature, e.g., typically the thermostated temperature of chip or body 100 as measured by element 124, the temperature versus resistance curve of element 124 has a slope substantially equal to the first predetermined slope of element 108 at its operating temperature. The total effective resistance of element 108 or 124, as appropriate, may then be adjusted by adding series resistor means 126 in series with either element 108 (this arrangement not shown) or 124 (as shown), series resistor means 126 having a substantially zero thermal coefficient of resistance over the temperature range of interest. As a result, the total effective resistance of the reference element may be made to be substantially equal at the second predetermined temperature to the total effective resistance of the pressure sensing element at the first predetermined temperature. In this manner, when the effective resistance of the reference and pressure sensing elements are substantially equal, signals through the two elements may be offset so that at a predetermined pressure the sum of the two signals will be substantially zero. Again this can be accomplished with a circuit substantially as shown in Figure 5.

Although the present pressure sensor has been described in such a manner that it could be sensitive to changing humidity levels, this is not considered to be a problem for typical applications since over the useful range of the present pressure sensor the response to changing pressure is large compared with a response to changing humidity.

When one first considers the phenomena related to the present pressure sensor, one might think that as the pressure of a gas decreases, i.e., as the density of the gas decreases, there should be fewer molecules to transport the heat away from a heated member means comprising a resistive element. Thus, with a constant current in the resistive element, if there were fewer molecules, it would seem that the member means would always run hotter as pressure decreases. Such is the case, however, only if the mean free path length of the molecules is an appreciable fraction of the dimension between the member means and the semiconductor body.

For pressures at which the mean free path length is short by comparison to the distance between the member means and the semiconductor body, the rate of heat transport away from the member means does not appreciably change with the changing pressure. Although a change in pressure, e.g., by 10%, causes the gas density to go down by a corresponding amount, the mean free path and, in fact, all path lengths of every category, go up by exactly the same amount, e.g., 10%, in order to compensate. Thus, for pressures at which the mean free path length is short by comparison to the distance between the member means and the semiconductor body, one can make the close approximations that molecules stop when they hit, and that the rate of heat transport away from the member means remains the same since, although there are fewer molecules, they go 10% further without being stopped. This is a very accurate dependency or compensation factor as long as the mean free path length of the gas molecules is short compared to the distance between the member means and the semiconductor body below it.

Accordingly, the present pressure sensor will not typically be sensitive to pressures near normal atmospheric pressures, e.g., in the range of one atmosphere to 0.1 atmosphere.

Generic device and processing

In terms of a particular preferred embodiment, it can be seen from the preceding examples that a permalloy resistive element acting as a heater and temperature sensor, in combination with the microstructure disclosed, is a generic device that provides the basis for sensing many physical variables such as air flow, humidity, pressure, combustible gases and other gaseous species. In fact, any physical quantity whose variation can cause a temperature change in a material structure can in principle be detected by means of a sensor based on structure such as disclosed.

Further, member means comprising, for example, a static electric element such as those disclosed can serve not only as a thermal-to-electric transducing element for the purpose of sensing but also as, for example, an electric-to-thermal element for providing electromagnetic radiation or otherwise serving as a source of thermal energy. Of course, such generic devices are not limited to having a permalloy resistive element, since any suitable thermal-to-electric or static electric element would suffice. Alternate examples of elements include a pyroelectric material such as a zinc oxide mono-crystalline film, a thin film thermocouple junction, a thermistor film of semiconducting material, or a metallic film other than permalloy with a favorable temperature coefficient of resistance.

Therefore, described more generally than in the specific examples preceding, and using the structure shown in Figures 1 through 4 as illustrative, the present invention comprises a semiconductor body 10 having a depression 20 etched into a first surface 14 of the body. The present invention further comprises member means 32 or 34 having a thermal-to-electric transducer or static electric element such as 16, the member means having a predetermined configuration suspended over depression 20, the member means being connected to first surface 14 at least at one location. The depression opens to first surface 14 around at least a portion of the predetermined configuration of the member means. The depression provides substantial physical and thermal isolation between the transducer or element and the semiconductor body.

Such an integrated semiconductor device can be fabricated through batch processing as further described below and provides an environment of substantial physical and thermal isolation between the transducer or element and the semiconductor body.

Fabrication of such a device in accordance with the present invention as defined in the claims comprises providing a semiconductor body with a first surface having a predetermined orientation with respect to a crystalline structure in the semiconductor body and applying a layer of material of which the member means is comprised onto the first surface. The present invention further comprises exposing at least one predetermined area of the first surface, the exposed surface area being bounded in part by the predetermined configuration to be suspended, the predetermined configuration being oriented so that undercutting of the predetermined configuration by an anisotropic etch will occur in a substantially minimum time.

The preferred implementation of the present invention comprises providing a (100) silicon wafer surface 14 which receives a layer of silicon nitride 12 typically 300 nm (3000 angstroms) thick that is deposited by standard sputtering techniques in a low pressure gas discharge. Next, a uniform layer of permalloy typically 80 percent nickel and 20 percent iron and 80 nm (800 angstroms) thick, is deposited on the silicon nitride by sputtering.

Using a suitable photo mask, a photoresist, and a suitable etchant, the permalloy element 22 comprising grid 16 and leads 24 are delineated.

A second layer 18 of silicon nitride, typically 500 nm (5000 angstroms) thick, is then sputter-deposited to provide complete step coverage of the permalloy configuration and thus protect the resistive element and its connections from oxidation. (Although making the first layer of silicon nitride 300 nm (3000 angstroms) thick and the second layer of silicon nitride (500 nm (5000 angstroms) thick results in a member means having non-symmetrical layers of dielectric, such lack of symmetry may be corrected by making the layers of equal thickness.) Openings 152 (Figures 10—13) are then etched through the nitride to the (100) silicon surface in order to delineate each member means. (Note that, although the member means are shown having straight edges, such configurations could be varied by, for example, having curved edges.)

Finally, an anisotropic etchant that does not attack the silicon nitride is used to etch out the silicon in a controlled manner from beneath the member means (KOH plus isopropyl alcohol is a suitable etchant). The sloping sides of the etched depression are bounded by (111) and other crystal surfaces that are resistive to the etchant, and the bottom of the depression, a (100) surface, which is much less resistant to the etchant, is located a specified distance (e.g. 0,1 mm) from the member means, typically by adjusting the duration of the etch. A doped silicon etch stop, e.g. a boron-doped layer, may also be used to control the depth of the depression, although such stops are not typically necessary when using the present invention.

In order to obtain undercutting of the member means in a minimum amount of time, the predetermined configuration of the member means, e.g., typically the straight edges or an axis of the member means, are oriented at a non-zero angle 154 to the [110] axis of the silicon (while the present invention will typically involve placing a straight member means edge or axis at an angle to minimize undercutting time [or permit undercutting, in the case of bridged member means], it is conceivable that a member means could be shaped such that no straight edges are involved or that no axis is easily defined but that the configuration itself is still oriented to achieve, for example, minimum undercutting time). By making such an angle substantially 45 degrees, the member means will be undercut in a minimum amount of time. For example, using the 45 degree angle, a cantilever beam of the typical dimensions disclosed elsewhere herein can be undercut in about 90 minutes by comparison to an etch time of several hours using a zero degree orientation.

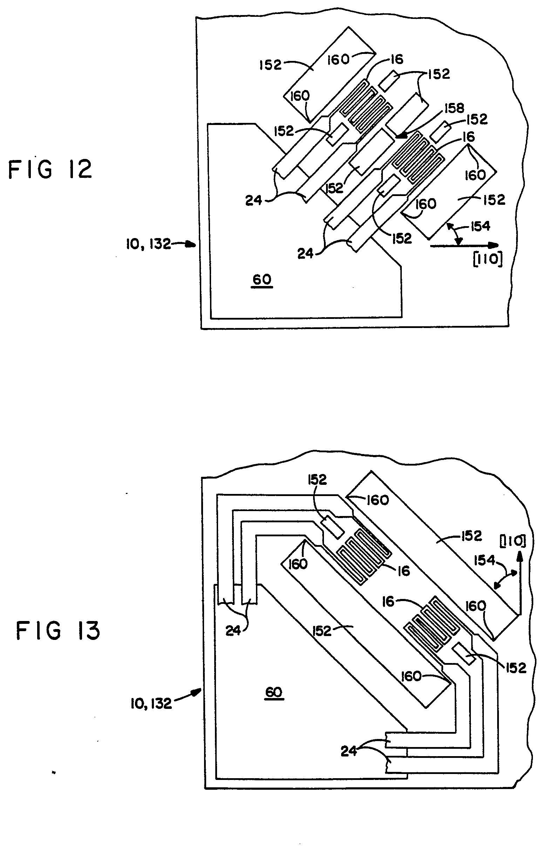

In addition to minimizing the amount of time in which the member means will be undercut, using a non-zero orientation permits fabrication of two ended bridges such as disclosed in Figure 1. Such member means are substantially impossible to make with the member means edges being oriented substantially with the [110] direction. This is because an anisotropic etch will not appreciably undercut at inside corners such as 160 (Figures 12 and 13) or at the (111) crystal planes exposed along the edges of the member means if the edges of member means are oriented with the [110] direction (the [110] oriented cantilevered member means taught in the prior art etch primarily along the length of the beam from the free end of the cantilever, there being little if any undercutting from the edges of the cantilever beam; this is in contrast to formation of member means through the present invention which, as previously explained, results in undercutting from directions including the edges of the member means).

The 45° orientation also permits rapid rounding and smoothing of the semiconductor end support interface with the member means, thus avoiding a stress concentration point that otherwise occurs where two (111) planes intersect beneath dielectric layer 12 (Figures 1—3).

It may be desirable in some device applications to connect first and second member means by a connecting means, thus in a sense providing first and second elements on a single member means. Examples of such connecting means are 156 shown in Figure 10 connecting two cantilevered member means such as shown in Figure 2, and connecting means 158 as shown in Figure 12 connecting two bridge-type member means of the type shown in Figure 1. Such connecting means help to maintain uniformity of spacing and, therefore, thermal conductance between each member means and the bottom of the depression, thus contributing to the uniformity of performance within each type of device. For similar reasons, it may be of advantage to place two elements on a single member means as shown by way of example in Figure 13.

It may also be desirable in some applications, either for processing or device configuration, to connect the member means to the semiconductor body at a secondary locations such as locations 159 shown in Figure 10.

Small rectangular etch holes 152 shown at the single connecting end of the cantilever-type member means shown in Figures 10 and 11 and at both ends of the bridge-type member means shown in Figures 12 and 13 help to provide further undercutting and forming of the semiconductor body where the member means are attached. However, such holes 152 at the ends of member means are not necessary to satisfactory performance of the devices.

Etch holes 152 running along side the member means shown have typical widths on the order of 0,05 mm to 0,125 mm for flow sensor and combustible gas sensor applications, the width of such apertures being on the order of 0,025 mm for typical humidity and pressure sensor applications, the narrower humidity sensor and pressure sensor width helping to reduce gas flow effects.

The semiconductor bodies in Figures 10—13 are indicated as alternately being either flow sensor configurations or combustible gas sensor configurations, the semiconductor bodies being alternately labeled 10 or 132. Layouts for humidity and pressure sensors, e.g., in accordance with Figure 6, would be similar, there typically being, however, only a single element and member means suspended over a depression in a humidity sensor.

Figures 10—13 also show a region 60 for integration of circuitry such as that illustrated in Figure 5.

As has previously been indicated, the practical effectiveness of the present invention for sensing by thermal means is achieved by making an air gap such as 20 (Figure 1) underneath member means 32 or 34. The result is that the sensing material is substantially thermally and physically isolated from the substrate by the air gap and is typically supported as in the disclosed embodiments, by a rectangular area of dielectric which remains attached at one or both ends to the silicon substrate (as previously indicated, although rectangular member means are typically used, virtually any other configuration could be used).

For the embodiments shown, typical dimensions of member means such as 32 or 34 are 0,125 mm—0,175 mm wide, 0,25 mm—0,5 mm long, and 0.8—1.2 µm thick. Typical permalloy elements such as element 16 illustrated in Figure 4 have a thickness of approximately 80 mm (800 angstroms) (typically in the range of approximately 80 mm (800 angstroms) to approximately 160 nm (1600 angstroms)) with a preferred composition of 80 percent nickel and 20 percent iron and a resistance value of about 1000 ohms at room temperature Resistance values for varying applications would typically be within the range of approximately 500 ohms to approximately 2000 ohms at room temperature, e.g. approximately 25°C (at permalloy element temperatures up to approximately 400°C, resistance values increase by a factor of up to approximately 3.0). Line widths within permalloy grid 16 may be approximately 6 µm having a 4 µm spacing. Depressions such as 20 typically have a 0,1 mm spacing between the member means and the semiconductor body such as 10, but their spacing could easily vary in the range of approximately 0,025 mm to approximately 0,25 mm. A typical thickness of a semiconductor body or substrate such as 10 is 0,2 mm. (The dimensions provided are illustrative only and are not to be taken as limitations.)

Member means of the typical dimensions indicated have a very small thermal capacity and thermal impedance that yield a thermal time constant of about 0.005 seconds. Consequently, a small change in heat input results in a new thermal balance at an appreciably different temperature of the sensing element. This difference can yield a substantial electrical output signal.

The strength-to-weight ratio for such a structure is very favorable, and a two-ended bridge of the above typical dimensions can withstand mechanical shock forces well in excess of 10,000 gravities. Even a single-ended structure of these dimensions when treated as a cantilever beam can be shown to withstand 10,000 gravities of shock.

It is a distinct advantage in many applications to heat the member means, e.g., 32 or 34 as shown in Figures 1 and 2, well above room or ambient temperature to optimize its sensing performance. Typical operating temperatures are in the range of approximately 100 to 400°C. Using the preferred permalloy element, this can be accomplished with only a few milliwatts of input power. Such power levels are compatible with integrated electronics which, as previously indicated, can be fabricated on the same semiconductor body with the sensor if desired.

A standard temperature sensor in industry has an electrical impedance of 100 ohms. However, for the purpose of the present invention, such as impedance has many disadvantages. For processing purposes, it is much more difficult to obtain a typical impedance precision of 0.1 percent with an impedance of 100 ohms rather than the typical 1000 ohm impedance preferred for the preferred resistive elements in the present invention. Element failure by electromigration is also a factor in choosing a typical impedance of 1000 ohms for permalloy elements used with the present invention. Electromigration is a physical failure mechanism within a conductor caused by mass flow when currents exceed a critical limit, typically on the order of $10^{-6}$ amperes per square centimeter in permalloy. Therefore, in order to achieve desired operating temperatures within permalloy elements such as 16, a relatively large impedance on the order of 1000 ohms at room temperature (e.g., 250°C) is desirable, the higher impedance resulting in the desired operating temperatures without exceeding critical current densities.

As a result, typical dimensions of the member means, e.g., 32, 34, as specified elsewhere herein must be substantially larger than the 0,024 mm wide by 0,1 mm long microstructures typically reported in the prior art. The larger area of the member means typically necessary for permalloy resistive elements compatible with the present invention are necessary to have sufficient surface area to mount a permalloy grid such as 16. Thus, the preferred 45° orientation of the member means discussed elsewhere herein becomes very important from a processing time standpoint, such as orientation resulting in a minimum processing time in creating the larger microstructures and permitting the creation of bridged microstructures such as shown in Figure 1.

As has been indicated for many contemplated applications the preferred thermal-to-electric transducer or static electric element is the permalloy resistive element previously described. When laminated within a silicon nitride member means, the permalloy element is protected from oxidation by air and can be used as a heating element to temperatures in excess of 400°C. Such a permalloy element has a resistance versus temperature characteristic similar to that of bulk platinum, both permalloy and platinum having a thermal coefficient of resistance (TCR) of about 4000 parts per million at 0°C. However, permalloy has been found superior to platinum for structures in accordance with the present invention. Although, platinum is a commonly used material for temperature sensitive resistors, permalloy has the advantage of a resistivity about twice that of platinum. Further, in thin films, permalloy achieves maximum TCR in the thickness range of about 80 to 160 nm (800 to 1600 angstroms), whereas platinum films must be at least 350 nm (3500 angstroms) thick (permalloy achieves its maximum TCR at a thickness of about 160 nm (1600 angstroms), but 80 nm (800 angstroms) has been selected as a preferred thickness since resistivity is doubled and TCR is only slightly less than at 160 nm (1600 angstroms)). Consequently, using a permalloy element 80 nm (800 angstroms) in thickness, the same resistance requires only one-eighth the surface area that would be required for platinum, thus increasing the thermal efficiency of the sensing means, reducing its required area, and lowering the unit cost.

Thus, the permalloy element is both an efficient heater element and an efficient sensing element for temperature changes of microstructures such as those disclosed, and the combination of both heating and sensing functions in the same element on a substantially thermally isolated structure makes possible its low cost, its small thermal capacity, and its favorable sensitivity and fast response.

Further, a permalloy heater/sensor laminated into a supporting insulating film of silicon nitride typically on the order of one micrometer thick provides passivation against oxygen, particularly at elevated temperatures, for the permalloy film. It also permits precision control of dimensions of the member means, e.g., 32, 34, because of the high resistance to process etching possessed by the silicon nitride. In addition, it permits deep etching to yield depressions such as 20 of dimensions such as 0,025 mm to 0,25 mm for control of the principal thermal conductance factor.

Accordingly, using preferred embodiments of the present invention, permalloy forms both a temperature sensor and heater/radiation source in combination with the microstructure disclosed. Use of silicon nitride as a supporting and passivating material permits etching times that are needed to achieve the desired structure. In addition, orientation in accordance with the present invention provides undercutting in a minimum amount of time and achieves the desired structure without artificial etch stops. In addition, the use of deep anisotropic etching to control depression depth to the 0,025 to 0,25 mm range achieves greater thermal isolation than is possible using conventional emplacements of thermal-to-electric or static electric elements in integrated semiconductor devices.

The present invention is to be limited only in accordance with the scope of the appended claims, since others skilled in the art may devise other embodiments and methods still within the limits of the claims.

**Claims**

1. An integrated semiconductor device, comprising a semiconductor body (10, 100, 137) having a depression (20, 102, 134) etched into a first surface (14, 104, 136) of said body, said body consisting of silicon having a (100) plane and a [110] direction and the first surface of the semiconductor body being substantially parallel to the (100) plane; and sensor means (32, 34, 106, 140, 148) being suspended over the depression (20, 102, 134) and connected to the first surface (14, 104, 136) at least at one location, said sensor means comprising a dielectric layer (12, 127, 144) as a supporting member and the depression opening to the first surface below and around said supporting member, characterized in that the sensor means comprises a static electric element (16, 108, 142, 150); and the supporting member is oriented at a non-zero angle (154) to the [110] direction of the silicon body (10, 100, 137).

2. Device according to claim 1, characterized in that said supporting member (12, 127, 144) is of substantially rectangular shape.

3. Device according to claim 1, characterized in that the non-zero angle (154) is substantially 45 degrees, whereby the sensor means (32, 34, 106, 140, 148) will be undercut with maximum efficiency.

4. Device according to one of claims 1 to 3, characterized in that the static electric element is a thermal-to-electric transducing element (16, 108, 142, 150).

5. Device according to claim 4, characterized in that the thermal-to-electric transducing element is a resistive element (16) which when provided with current becoming heated, there being a predetermined relationship between the resistance and the temperature of the resistive element, the resistive element being adapted to provide a signal related to the rate of air flowing over the sensor means (32, 34), whereby air flowing over the sensor means will cause the resistive element to cool in predetermined relation to the rate of air flow, thus causing a change in resistance and providing a measurement of air flow rate.

6. Device according to claim 4, characterized in that the thermal-to-electric transducing element is a resistive element (142); the sensor means (140) further comprises reactive means (130) thermally coupled to the resistive element (142) the resistive element (142) when provided with current becomes heated, there being a predetermined relationship between the resistance and the temperature of the resistive element (142); no-flow means (116, 118, 120) are provided for substantially preventing air flow over the sensor means (140), thus substantially preventing cooling of the resistive element (142) due to air flow; and the reactive means (130) when heated in the presence of a combustible gas and oxygen is providing an indication of the presence of a combustible gas.

7. Device according to one of claims 2 to 7, characterized in that rectangular-shaped supporting member has an area greater than approximately $6 \cdot 10^{-5}$ cm$^2$.

8. Device according to one of claims 1 to 7, characterized in that the sensor means (32, 34, 106, 140, 148) has a thickness in the range of approximately 0.8 µm to approximately 1.2 µm.

9. Device according to one of claims 1 to 8, characterized in that the depression (20, 102, 134) has a depth as measured between the sensor means (32, 34, 106, 140, 148) and the semiconductor body (10, 100, 132) in the range of approximately 0,025 mm to pproximately 0,25 mm.

10. Device according to claim 5 or 6, characterized in that the resistive element comprises a permalloy element (16, 108, 142, 150).

11. Device according to claim 10, characterized in that the permalloy element (16, 108, 142, 150) has a thickness in the range of approximately 80 nm to approximately 160 nm.

12. Device according to claim 11, characterized in that the permalloy element (16, 108, 142, 148) has a composition of approximately 80% nickel and approximately 20% iron.

13. Device according to claim 12, characterized in that the permalloy element (16, 108, 140, 148) has a resistance in the range of approximately 500Ω to approximately 2000Ω at 25°C.

14. Device according to claim 13, characterized in that the sensor means (32, 34, 106, 140, 148) comprises a further dielectric layer (18, 129, 146) encapsulating the permalloy element (16, 108, 142, 150).

15. Device according to claim 14, characterized in that the supporting member (12, 127, 144) and the further dielectric layer (19, 129, 146) comprise silicon nitride.

16. Device according to one of claims 1 to 15, characterized in that the sensor means (32, 34, 106, 140, 148) is connected to the first surface (14, 104, 136) at first and second substantially opposing ends (38, 40) so that it bridges the depression.

17. Device according to claim 6 characterized in that the reactive means (130) comprises a material selected from the group consisting of iron oxide, platinum and palladium.

18. Device according to claim 5 or 6, characterized in that said sensor means (32, 34; 140, 148) comprises first and second resistive elements (16A, 16B; 142, 150) providing first and second signals which may be offset so that at a predetermined rate of flow or at the presence of a combustible gas at the reactive means (130), respectively, the difference between the first and second signals has a predetermined value.

19. Device according to claim 18, characterized in that said first and second resistive elements (16A, 16B; 142, 150) are arranged on first and second sensor means (32, 34; 140, 148) and that said first and second elements and sensor means are substantially identical.

20. Device according to claim 19, characterized by a circuit (60) connected to said first and second resistive elements (16A, 16B; 142, 150) for offsetting the first and second signals.

21. Device according to claim 20, characterized in that said circuit (60) is integrated on the semiconductor body (10, 132).

22. Device according to claim 21, characterized in that the difference between the first and second signals is substantially zero at a substantially zero flow rate or when a combustible gas is not present at the reactive element (130), respectively.

23. Device according to claim 6, characterized in that the reactive means (130) when heated in the presence of a combustible gas and oxygen causes an exothermic reaction, thus causing a change in temperature and accordingly, resistance of the resistive element (142).

24. Device according to claim 6, characterized in that the reactive means (130) comprises a resistive element (16) that changes in resistance when heated in the presence of a combustible gas and oxygen.

25. Device according to claim 24, characterized in that the resistive element (16) comprises a metal oxide.

26. Device according to claim 25, characterized in that the metal oxide is selected from the group consisting of iron oxide and tin oxide.

27. Device according to claim 4, characterized in that the thermal-to-electric transducing element is a resistive element (108) which when provided with current becoming heated, there being a predetermined relationship between the resistance and the temperature of the resistive element; no-flow means (116, 118, 120) are provided for substantially preventing air flow over the sensor means (106), thus substantially preventing cooling of the resistive element (108) due to air flow, the no-flow means permitting a humidity level between the sensor means (106) and the semiconductor body (100) to substantially equalize with the humidity level in the surrounding environment; the resistive element (108) being adapted to provide a signal related to the resistance, and therefore, the temperature of the resistive element, the signal varying with humidity due to varying thermal coupling between the resistive element (108) and the semiconductor body (100), the varying thermal coupling arising through the varying conductivity of air with varying humidity, the signal thus providing a measurement of humidity.

28. Device according to claim 4, characterized in that the thermal-to-electric transducing element is a resistive element (108) which when provided with current becoming heated, there being a predetermined relationship between the resistance and the temperature of the resistive element; no-flow means (116, 118, 120) are provided for substantially preventing air flow over the sensor means (106), thus substantially preventing cooling of the resistive element (108) due to air flow, the no-flow means permitting the pressure level between the sensor means (106) and the semiconductor body (100) to substantially equalize with the pressure level in the surrounding environment; the resistive element (108) being adapted to provide a signal related to the resistance, and therefore, the temperature of the resistive element, the signal varying with pressure due to varying thermal coupling between the resistive element (108) and the semiconductor body (100), the varying thermal coupling arising through the varying conductivity of a gas with varying pressure, the signal thus providing a measurement of pressure.

29. Device according to claims 27 and 28, characterized by a reference resistor (122, 124, 126) for carrying a second predetermined current, whereat said reference resistor being substantially heat sunk to the semiconductor body (100) and being adapted to provide a second signal related to the resistance of the reference resistor, there being a predetermined relationship between the resistance and the temperature of the reference resistor with the temperature of the reference resistor being substantially regulated by the temperature of the semiconductor body, whereby under predetermined conditions of humidity and pressure, respectively, and of current, the difference between the two signals has a predetermined value.

30. Device according to claim 29, characterized in that the reference resistor (122, 124, 126) comprises a second permalloy element (124); the temperature versus resistance curve of each permalloy element (108, 124) is nonlinear; the temperature versus resistance curve of the resistive element (108) has a first predetermined slope when operating at the first predetermined temperature; the resistance of the reference resistor (122, 124, 126) being established so that at a second predetermined temperature the temperature versus resistance curve of the reference resistor has a slope substantially equal to the first predetermined slope; one of the resistive elements (108) and the reference resistor (122, 124, 126) comprises a series resistor (126) connected in series to the one of the resistive elements (108) and the reference resistor (124), the series resistor (126) having a substantially zero thermal coefficient of resistance, the total resistance of the series resistor (124) and the one of the resistive elements (108) and the reference resistor (124) being substantially equal at the second predetermined temperature to the total resistance of the other of the resistive elements (108) and the reference resistor (124) at the first predetermined temperature; whereby when the first and second currents are substantially equal to the first and second signals may be offset so that at a predetermined humidity and pressure, respectively, the sum of the first and second signals will be substantially zero.

31. Device according to claim 30, characterized in that the semiconductor body (100) comprises heater means (128) for controlling the temperature of the semiconductor body to a predetermined temperature.

32. Method of fabricating a semiconductor device according to one of claims 1 to 31 comprising the following steps:

a) applying a dielectric layer (12, 127, 144) onto said first surface (14, 104, 136) of said semiconductor body (10, 100, 132);

b) forming at least one static electric element (16, 108, 142, 150) on said dielectric layer;

c) exposing at least one predetermined area (152) of said first surface (14, 104, 136) in order to delineate each sensor means (32, 34, 106, 140, 148), the exposed surface area (152) being bounded in part by said sensor means to be suspended, with said sensor means being oriented at said non-zero angle to the [110] direction of said silicon body so that an anisotropic etch placed on the exposed surface area (152) will undercut the sensor means in a substantially minimum time; and

d) applying the anisotropic etch to the exposed surface area (152) to undercut the sensor means (32, 34, 106, 140, 148) and create the depression (20, 102, 134).

**Patentansprüche**

1. Integrierte Halbleitervorrichtung mit einem Halbleiterkörper (10, 100, 137), welcher eine in eine erste Oberfläche (14, 104, 136) eingeätzte Ausnehmung (20, 102, 134), aufweist, wobei der Körper aus Silizium mit einer (100)-Ebene und einer [110]-Vorzugsrichtung besteht und die erste Oberfläche des Halbleiterkörpers im wesentlichen parallel zu der (100)-Ebene verläuft; und mit Sensoreinrichtungen (32, 34, 106, 140, 148), die sich über die Ausnehmungen (10, 102, 134) erstrecken und mit der ersten Oberfläche (14, 104, 136) an wenigstens einer stelle verbunden sind, wobei die Sensoreinrichtungen eine dielektrische Schicht (12, 127, 144) als Stützeinrichtung aufweisen und sich die Ausnehmung zu der ersten Oberfläche unterhalb und um die Stützeinrichtungen öffnet, dadurch gekennzeichnet, daß die Sensoreinrichtungen ein statisches elektrisches Element (16, 108, 142, 150) umfassen; und die Stützeinrichtung unter einem von Null abweichenden Winkel (154) zu der [110]-Vorzugsrichtung des Siliziumkörpers (10, 100, 137) gerichtet ist.

2. Vorrichtung nach Anspruch 1, dadurch gekennzeichnet, daß die Stützeinrichtung (12, 127, 144) eine im wesentlichen rechteckige Form aufweist.

3. Vorrichtung nach Anspruch 1, dadurch gekennzeichnet, daß der von Null abweichende Winkel (154) im wesentlichen 45° beträgt, wobei die Sensoreinrichtungen (32, 34, 106, 140, 148) mit maximaler Wirksamkeit unterschnitten werden.

4. Vorrichtung nach einem der Ansprüche 1 bis 3, dadurch gekennzeichnet, daß das statische elektrische Element ein thermisch-elektrisches Wanderelement (16, 108, 142, 150) ist.

5. Vorrichtung nach Anspruch 4, dadurch gekennzeichnet, daß das thermisch-elektrische Wandlerelement ein Widerstandselement (16) ist, welches sich bei Stromzufuhr erhitzt, wobei eine vorbestimmte Beziehung zwischen dem Widerstand und der Temperatur des Widerstandselementes besteht, daß das Widerstandselement geeignet ist, ein Signal entsprechend der über die Sensoreinrichtungen (32, 34) strömenden Luftmenge zu liefern, wobei die über die Sensoreinrichtungen strömende Luft eine Abkühlung des Widerstandselementes hervorruft, die in vorbestimmter Beziehung zur Luftfließgeschwindigkeit steht, so daß eine Widerstandsänderung hervorgerufen und ein Maß für die Luftfließgeschwindigkeit gebildet wird.

6. Vorrichtung nach Anspruch 4, dadurch gekennzeichnet, daß das thermisch-elektrische Wandlerelement ein Widerstandselement (142) ist; daß die Sensoreinrichtung (140) ferner eine thermisch mit dem Widerstandselement (142) gekoppelte reaktive Einrichtung (130) aufweist; daß das Widerstandselement bei Stromzufuhr aufgeheizt wird, wobei eine vorbestimmte Beziehung zwischen dem Widerstand und der Temperatur des Widerstandselementes (142) besteht; daß Fließverhinderungseinrichtungen (116, 118, 120) vorgesehen sind, um im wesentlichen einen Luftfluß über die Sensoreinrichtung (140) und somit im wesentlichen eine Abkühlung des Widerstandselementes (142) aufgrund des Luftflusses zu verhindern; und daß die reaktive Einrichtung (130) beim Aufheizen in Gegenwart eines brennbaren Gases und Sauerstoff eine Anzeige des Vorhandenseins von brennbarem Gas liefert.

7. Vorrichtung nach einem der Ansprüche 2 bis 6, dadurch gekennzeichnet, daß die rechteckförmige Stützeinrichtung eine Fläche größer als ungefähr $6 \cdot 10^{-5}$ cm$^2$ aufweist.

8. Vorrichtung nach einem der Ansprüche 1 bis 7, dadurch gekennzeichnet, daß die Sensoreinrichtung (32, 34, 106, 140, 148) eine Dicke im Bereich von ungefähr 0,8 µm bis ungefähr 1,2 µm aufweist.

9. Vorrichtung nach einem der Ansprüche 1 bis 8, dadurch gekennzeichnet, daß die Ausnehmung (20, 102, 134) eine Tiefe im Bereich von ungefähr 0,025 mm bis ungefähr 0,25 mm zwischen der Sensoreinrichtung (32, 34, 106, 140, 148) und dem Halbleiterkörper (10, 100, 132) aufweist.

10. Vorrichtung nach Anspruch 5 oder 6, dadurch gekennzeichnet, daß das Widerstandselement ein Permalloy-Element (16, 108, 142, 150) umfaßt.

11. Vorrichtung nach Anspruch 10, dadurch gekennzeichnet, daß das Permalloy-Element (16, 108, 142, 150) eine Dicke im Bereich von ungefähr 80 nm bis ungefähr 160 nm aufweist.

12. Vorrichtung nach Anspruch 11, dadurch gekennzeichnet, daß das Permalloy-Element (16, 108, 142, 148) eine Zusammensetzung aus ungefähr 80% Nickel und ungefähr 20% Eisen aufweist.

13. Vorrichtung nach Anspruch 12, dadurch gekennzeichnet, daß das Permalloy-Element (16, 108, 140, 148) einen Widerstand im Bereich von ungefähr 500Ω bis ungefähr 2000Ω bei 25°C besitzt.

14. Vorrichtung nach Anspruch 13, dadurch gekennzeichnet, daß die Sensoreinrichtung (32, 34, 106, 140, 148) eine weitere dielektrische Schicht (18, 129, 146) umfaßt, die das Permalloy-Element (16, 108, 142, 150) umkapselt.

15. Vorrichtung nach Anspruch 14, dadurch gekennzeichnet, daß die Stützeinrichtung (12, 127, 144) und die weitere dielektrische Schicht (18, 129, 146) Siliziumnitrid aufweisen.

16. Vorrichtung nach einem der Ansprüche 1 bis 15, dadurch gekennzeichnet, daß die Sensoreinrichtung (32, 34, 106, 140, 148) mit der ersten Oberfläche (14, 104, 136) an ersten und zweiten sich im wesentlichen gegenüberliegenden Enden (38, 40) verbunden ist, so daß sie die Ausnehmung überbrückt.

17. Vorrichtung nach Anspruch 16, dadurch gekennzeichnet, daß die reaktive Einrichtung (130) ein Material umfaßt, das aus der Gruppe bestehend aus Eisenoxyd, Platin und Palladium ausgewählt ist.

18. Vorrichtung nach Anspruch 5 oder 6, dadurch gekennzeichnet, daß die Sensoreinrichtung (32, 34; 140, 148) erste und zweite Widerstandselemente (16A, 16B; 142, 150) umfaßt, die erste und zweite Signale liefern, welche zueinander verschoben sein können, so daß bei einer vorbestimmten Fließgeschwindigkeit oder beim Vorhandensein eines brennbaren Gases an der reaktiven Einrichtung (130) die Differenz zwischen den ersten und zweiten Signalen einen vorbestimmten Wert aufweist.

19. Vorrichtung nach Anspruch 18, dadurch gekennzeichnet, daß die ersten und zweiten Widerstandselemente (16A, 16B; 142, 150) auf ersten und zweiten Sensoreinrichtungen (32, 34; 140, 148) angeordnet sind und daß die ersten und zweiten Elemente und die Sensoreinrichtungen im wesentlichen identische sind.

20. Vorrichtung nach Anspruch 19, gekennzeichnet durch einen Schaltkreis (60), der an die ersten und zweiten Widerstandselemente (16A, 16B; 142, 150) angeschlossen ist, um die ersten und zweiten Signale zueinander zu verschieben.

21. Vorrichtung nach Anspruch 20, dadurch gekennzeichnet, daß der Schaltkreis (60) auf dem Halbleiterkörper (10, 132) integriert ist.

22. Vorrichtung nach Anspruch 21, dadurch gekennzeichnet, daß die Differenz zwischen den ersten und zweiten Signalen im wesentlichen Null beträgt bei einer Fließgeschwindigkeit von im wesentlichen Null oder wenn ein brennbares Gas an dem reaktiven Element (130) nicht vorliegt.

23. Vorrichtung nach Anspruch 6, dadurch gekennzeichnet, daß das reaktive Element (130) bei seiner Aufheizung in Gegenwart eines brennbaren Gases und Sauerstoff eine exothermische Reaktion hervorruft, wodurch eine Temperaturänderung und dementsprechend eine Widerstandsänderung des Widerstandselementes (142) hervorgerufen wird.

24. Vorrichtung nach Anspruch 6, dadurch gekennzeichnet, daß das reaktive Element (130) ein Widerstandselement (16) umfaßt, das seinen Widerstand verändert, wenn es in Gegenwart eines brennbaren Gases und Sauerstoff aufgeheizt wird.

25. Vorrichtung nach Anspruch 24, dadurch gekennzeichnet, daß das Widerstandselement (16) in Metalloxyd umfaßt.

26. Vorrichtung nach Anspruch 25, dadurch gekennzeichnet, daß das Metalloxyd aus der Gruppe bestehend aus Eisenoxyd und Zinnoxyd ausgewählt ist.

27. Vorrichtung nach Anspruch 4, dadurch gekennzeichnet, daß das thermisch-elektrische Wandlerelement ein Widerstandselement (108) ist, welches sich bei Stromzuführung erhitzt, wobei eine vorbestimmte Beziehung zwischen dem Widerstand und der Temperatur des Widerstandselementes besteht; daß Fließverhinderungseinrichtungen (116, 118, 120) vorgesehen sind, um im wesentlichen einen Luftfluß über die Sensoreinrichtung (106) zu verhindern und somit im wesentlichen die Abkühlung des Widerstandselementes (108) aufgrund des Luftflusses zu verhindern, wobei die Fließverhinderungseinrichtung einem Feuchtigkeitspegel zwischen der Sensoreinrichtung (106) und dem Halbleiterkörper (100) die Angleichung an einen Feuchtigkeitspegel der Umgebung gestattet; daß das Widerstandselement (108) ein auf den Widerstand und daher auf die Temperatur des Widerstandselementes bezogenes Signal zu liefern vermag, wobei das Signal mit der Feuchtigkeit aufgrund der veränderlichen thermischen Kopplung zwischen dem Widerstandselement (108) und dem Halbleiterkörper (100) variiert, die veränderliche thermische Kopplung durch die veränderliche Leitfähigkeit der Luft mit veränderlicher Feuchtigkeit entsteht und das Signal somit eine Messung der Feuchtigkeit liefert.

28. Vorrichtung nach Anspruch 4, dadurch gekennzeichnet, daß das thermisch-elektrische Wandlerelement ein Widerstandselement (108) ist, welches sich bei Stromzufuhr erhitzt, wobei eine vorbestimmte Beziehung zwischen dem Widerstand und der Temperatur des Widerstandselementes besteht; Fließverhinderungseinrichtungen (116, 118, 120) vorgesehen sind, um im wesentlichen einen Luftfluß über die Sensoreinrichtung (106) zu verhindern und somit im wesentlichen die Abkühlung des Widerstandselementes (108) aufgrund des Luftflusses zu verhindern, wobei die Fließverhinderungseinrichtung einem Druckpegel zwischen der Sensoreinrichtung (106) und dem Halbleiterkörper (100) die Augleichung an einen Druckpegel der Umgebung gestattet; das Widerstandselement (108) ein auf den Widerstand und daher auf die Temperatur des Widerstandselementes bezogenes Signal zu liefern vermag, wobei das Signal mit dem Pegel aufgrund der veränderlichen thermischen Kopplung zwischen dem Widerstandselement (108) und dem Halbleiterkörper (100) variiert, die veränderliche thermische Kopplung durch die veränderliche Leitfähigkeit eines Gases mit veränderlichem Druck entsteht und das Signal somit eine Messung des Druckes liefert.

29. Vorrichtung nach den Ansprüchen 27 und 28, gekennzeichnet durch einen Referenzwiderstand (122, 124, 126) zur Führung eines zweiten vorbestimmten Stromes, wobei dieser Referenzwiderstand im wesentlichen wärmeleitfähig mit dem Halbleiterkörper (100) verbunden ist und ein zweites Signal bezogen auf den Widerstand des Referenzwiderstandes liefert, so daß eine vorbestimmte Beziehung zwischen dem Widerstand und der Temperatur des Referenzwiderstandes besteht und die Temperatur des Referenzwiderstandes im wesentlichen durch die Temperatur des Halbleiterkörpers geregelt wird, wobei unter vorbestimmten Feuchtigkeits- und Druckbedingungen und des Stromes die Differenz zwischen den zwei Signalen einen vorbestimmten Wert aufweist.

30. Vorrichtung nach Anspruch 29, dadurch gekennzeichnet, daß der Referenzwiderstand (122, 124, 126) ein zweites Permalloy-Element (124) umfaßt; die Temperatur/Widerstands-Kurve jedes Permalloy-Elementes (108, 124) nicht-linear ist; die Temperatur/Widerstands-Kurve des Widerstandselementes (108) eine erste vorbestimmte Neigung aufweist, wenn es mit der ersten vorbestimmten Temperatur betrieben wird; der Widerstand des Referenzwiderstandes (122, 124, 126) so eingestellt wird, daß bei einer zweiten vorbestimmten Temperatur die Temperatur/Widerstands-Kurve des Referenzwiderstandes eine im wesentlichen zu der ersten vorbestimmten Neigung gleiche Neigung aufweist; eines der Widerstandselemente (108) und der Referenzwiderstand (122, 124, 126) einen Reihenwiderstand (126) in Serie zu einem der Widerstandselemente (108) und zu dem Referenzwiderstand (124) aufweist, wobei der Reihenwiderstand (126) im wesentlichen einen thermischen Widerstandskoeffizienten von Null aufweist und der Gesamtwiderstand aus dem Reihenwiderstand (126), dem einen Widerstandselement (108) und dem Referenzwiderstand (124) bei der zweiten vorbestimmten Temperatur im wesentlichen gleich dem Gesamtwiderstand aus dem anderen Widerstandselement (108) und dem Referenzwiderstand (124) bei der ersten vorbestimmten Temperatur ist; wobei, wenn die ersten und zweiten Ströme im wesentlichen gleich sind, die ersten und zweiten Signale versetzt sein können, so daß bei einer vorbestimmten Feuchtigkeit bzw. einem vorbestimmten Druck die Summe der ersten und zweiten Signale im wesentlichen Null ist.

31. Vorrichtung nach Anspruch 30, dadurch gekennzeichnet, daß der Halbleiterkörper (100) eine Heizeinrichtung (128) für die Steuerung der Temperatur des Halbleiterkörpers auf einem vorbestimmten Wert aufweist.

32. Verfahren zur Herstellung einer Halbleitervorrichtung gemäß einem der Ansprüche 1 bis 31, umfassend folgende Schritte:

a) Aufbringung einer dielektrischen Schicht (12, 127, 144) auf die erste Oberfläche (14, 106, 136) des Halbleiterkörpers (10, 100, 132);

b) Bildung wenigstens eines statischen elektrischen Elementes (16, 108, 142, 150) auf der dielektrischen Schicht;

c) Belichtung wenigstens eines vorbestimmten Bereiches (152) der ersten Oberfläche (14, 104, 136), um jede Sensoreinrichtung (32, 34, 106, 140, 148) aufzuzeichnen, wobei der belichtete Oberflächenbereich (152) teilweise durch die aufzuhängenden Sensoreinrichtungen begrenzt ist und die Sensoreinrichtungen unter dem von Null abweichenden Winkel zu der [110]-Vorzugsrichtung des Siliziumkörpers gerichtet sind, so daß eine anisotrope Ätzung des belichteten Oberflächenbereiches (152) in einer minimalen Zeit die Sensoreinrichtungen unterschneidet; und

d) Anwendung der anisotropischen Ätzung auf den belichteten Oberflächenbereich (152), um die Sensoreinrichtungen (32, 34, 106, 140, 148) zu unterschneiden und die Ausnehmungen (20, 102, 134) zu schaffen.

## Revendications

1. Dispositif intégré à semiconducteurs, comportant un corps semiconducteur (10, 100, 137) comportant un renfoncement (20, 102, 134) formé par corrosion dans une première surface (14, 104, 136) dudit corps, ledit corps étant constitué par du silicium possédant un plan (100) et une direction [110] et la première surface du corps semiconducteur étant sensiblement parallèle au plan (100); et des moyens formant capteurs (32, 34, 106, 140, 148) suspendus au-dessus du renfoncement (20, 102, 134) et raccordés à la première surface (14, 104, 136) au moins en un emplacement, lesdits moyens formant capteurs comprenant une couche diélectrique (12, 127, 144) formant élément de support, et le renfoncement débouchant dans la première surface au-dessous et autour dudit élément de support, caractérisé en ce que les moyens formant capteur comprennent un élément électrique statique (16, 108, 142, 150); et l'élément de support est orienté de manière à faire un angle non nul (154) par rapport à la direction [110] du corps en silicium (10, 100, 137).

2. Dispositif selon la revendication 1, caractérisé en ce que ledit élément de support (12, 127, 144) possède une forme sensiblement rectangulaire.

3. Dispositif selon la revendication 1, caractérisé en ce que l'angle non nul (154) est égal sensiblement à 45 degrés, ce qui a pour effet qu'un évidement sous-jacent est formé sous les moyens formant capteur (32, 34, 106, 140, 148), avec un rendement maximum.

4. Dispositif selon l'une des revendications 1 à 3, caractérisé en ce que l'élément électrique statique est un élément transducteur de conversion thermique/électrique (16, 108, 142, 150).

5. Dispositif selon la revendication 4, caractérisé en ce que l'élément transducteur pour la conversion thermique/électrique est un élément résistif (16), qui devient chaud lorsqu'il est alimenté par un courant, une relation prédéterminée existant entre la valeur résistive et la température de l'élément résistif, l'élément résistif étant adapté pour fournir un signal associé au débit de l'air circulant au-dessus des moyens formant capteur (22, 34), ce qui a pour effet que l'air circulant au-dessus les moyens formant capteur provoque un refroidissement de l'élément résistif conformément à une relation prédéterminée par rapport au débit d'air, ce qui provoque une variation de la valeur résistive et fournit une mesure du débit d'air.

6. Dispositif selon la revendication 4, caractérisé en ce que l'élément transducteur pour la conversion thermique-électrique est un élément résistif (132); les moyens formant capteurs (140) comprennent en outre des moyens réactif (130) accouplés thermiquement à l'élément résistif (142); l'élément résistif (142) devient chaud lorsqu'il est alimenté par un courant, une relation prédéterminée existant entre la valeur résistive et la température de l'élément résistif (140); des moyens (116, 118, 120) de blocage de l'écoulement sont prévus pour empêcher sensiblement un écoulement d'air au-dessus des moyens formant capteurs (140), ce qui empêche pour l'essentiel un refroidissement de l'élément résistif (142) dû à l'écoulement d'air; et, lorsqu'ils sont chauffés en présence d'un gaz combustible et l'oxygène, les moyens réactifs (130) délivrent une indication de la présence du gaz combustible.

7. Dispositif selon l'une quelconque des revendications 2 à 6, caractérisé en ce que l'élément de support de forme rectangulaire possède une surface supérieure à environ $6 \times 10^{-5}$ cm².

8. Dispositif selon l'une des revendications 1 à 7, caractérisé en ce que les moyens formant capteur (32, 34, 106, 140, 148) possèdent une épaisseur se situant dans la gamme comprise entre environ 0,8 µm et environ 1,2 µm.

9. Dispositif selon l'une des revendications 1 à 8, caractérisé en ce que le renfoncement (20, 102, 104) possède une profondeur, mesurée entre les moyens formant capteur (32, 34, 106, 140, 148) et le corps semiconducteur (10, 100, 132), qui sie situe dans la gamme comprise entre environ 0,025 mm et environ 0,25 mm.

10. Dispositif selon la revendication 5 ou 6, caractérisé en ce que l'élément résistif comprend un élément en permalloy (16, 108, 142, 150).

11. Dispositif selon la revendication 10, caractérisé en ce que l'élément en permalloy (16, 108, 142, 150) possède une épaisseur située dans la gamme comprise entre environ 80 nm et environ 160 nm.

12. Dispositif selon la revendication 11, caractérisé en ce que l'élément en permalloy (16, 108, 142, 148) possède une composition incluant environ 80% de nickel et environ 20% der fer.

13. Dispositif selon la revendication 12, caractérisé en ce que l'élément en permalloy (16, 108, 140, 142) possède une résistance située dans la gamme comprise entre environ 500 Ω et environ 2000 Ω à 25°C.

14. Dispositif selon la revendication 13, caractérisé en ce que les moyens formant capteur (32, 34, 106, 140, 148) comprennent une couche diélectrique supplémentaire (18, 129, 146) encapsulant l'élément en permalloy (16, 148, 142, 150).

15. Dispositif selon la revendication 14, caractérisé en ce que l'élément de support (12, 127, 144) et la couche diélectrique supplémentaire (18, 129, 146) sont constitués par du nitrure de silicium.

16. Dispositif selon l'une des revendications 1 à 4, caractérisé en ce que les moyens formant capteur (32, 34, 140, 148) sont raccordés à la première surface (14, 104, 136) au niveau de première et seconde extrémités sensiblement opposées (38, 40), de sorte qu'ils recouvrent le renfoncement.

17. Dispositif selon la revendication 6, caractérisé en ce que les moyens réactifs (130) sont constitués en un matériau choisi dans le groupe incluant l'oxyde de fer, le platine et le palladium.

18. Dispositif selon la revendication 5 ou 6, caractérisé en ce que lesdits moyens formant capteur (32, 34, 140, 148) comprennent des premier et second éléments résistifs (16A, 16B, 142, 150) fournissant des premier et second signaux, qui peuvent être décalés de sorte que, pour un débit prédéterminé d'écoulement ou bien dans le cas de la présence d'un gaz combustible au niveau des moyens réactifs (130), la différence entre les premier et second signaux possède une valeur prédéterminée.

19. Dispositif selon la revendication 18, caractérisé en ce que lesdits premier et second éléments résistifs (16A, 16B; 142, 150) sont disposés sur les premier et second moyens formant capteurs (32, 34; 140, 150) et que lesdits premier et second éléments et les moyens formant capteurs sont sensiblement identiques.

20. Dispositif selon la revendication 19, caractérisé par un circuit (60) raccordé auxdits premier et second éléments résistifs (16A, 16B; 142, 150) pour réaliser le décalage entre les premier et second signaux.

21. Dispositif selon la revendication 20, caractérisé en ce que ledit circuit (60) est intégré dans le corps semiconducteur (10, 132).

22. Dispositif selon la revendication 21, caractérisé en ce que la différence entre les premier et second signaux est sensiblement nulle pour un débit sensiblement nul de l'écoulement ou bien lorsqu'aucun gaz combustible n'est présent au niveau de l'élément réactif (103).

23. Dispositif selon la revendication 6, caractérisé en ce que, lorsqu'ils sont chauffés en présence d'un gaz combustible et d'oxygène, les moyens réactifs (130) déclenchent une réaction exothermique, ce qui provoque une modification de la température et, par conséquent, de la valeur résistive de l'élément résistif (142).

24. Dispositif selon la revendication 6, caractérisé en ce que les moyens réactifs (103) comprennent un élément résistif (16), dont la valeur résistive varie lorsqu'il est chauffé en présence d'un gaz combustible et d'oxygène.

25. Dispositif selon la revendication 24, caractérisé en ce que l'élément résistif (16) est constitué pa un oxyde métallique.

26. Dispositif selon la revendication 25, caractérisé en ce que l'oxyde métallique est choisi dans le groupe incluant l'oxyde de fer et l'oxyde d'étain.

27. Dispositif selon la revendication 4, caractérisé en ce que l'élément transducteur pour la conversion thermique/électrique est un élément résistif (108), qui devient chaud, lorsqu'il est alimenté par un courant, une relation prédéterminée existant entre la valeur résistive et la température de l'élément résistif; des moyens (116, 118, 120) de blocage de l'écoulement sont prévus pour empêcher sensiblement un écoulement d'air au-dessus des moyens formant capteur (106), ce qui empêche, pour l'essentiel, un refroidissement de l'élément résistif (108) par l'écoulement d'air, les moyens de blocage de l'écoulement permettant sensiblement que le niveau d'humidité présent entre les moyens formant capteur (106) et le corps semiconducteur (100) devienne sensiblement égal au niveau d'humidité présent dans l'environnement alentour; l'élément résistif (108) étant adapté pour délivrer un signal associé à la valeur résistive, et, par conséquent, à la température de l'élément résistif, le signal variant avec l'humidité en raison d'un couplage thermique variable entre l'élément résistif (108) et le corps semiconducteur (100), l'accouplement thermique variable étant provoqué par la variation de la conductivité de l'air obtenue lorsque l'humidité varie, le signal fournissant de ce fait une mesure de l'humidité.

28. Dispositif selon la revendication 4, caractérisé en ce que l'élément transducteur pour la conversion thermique/électrique est un élément résistif (108), qui devient chaud, lorsqu'il est alimenté par un courant, une relation prédéterminée existant entre la valeur résistive et la température de l'élément résistif; des moyens (116, 118, 120) de blocage de l'écoulement sont prévus pour empêcher sensiblement un écoulement d'air au-dessus des moyens formant capteur (106), ce qui empêche, pour l'essentiel un refroidissement de l'élément résistif (108) par l'écoulement d'air, les moyens de blocage d'écoulement permettant sensiblement que le niveau d'humidité présent entre les moyens formant capteur (106) et le corps semiconducteur (100) devienne sensiblement égal au niveau d'humidité présent dans l'environnement alentour; l'élément résistif (108) est adapté pour délivrer un signal associé à la valeur résistive et, par conséquent, à la température de l'élément résistif, ce signal variant en fonction de la pression en raison d'un couplage thermique variable présent entre l'élément résistif (108) et le corps semiconducteur (100), le couplage thermique variable étant provoqué par la variation de la conductivité d'un gaz en fonction de la variation de la pression, le signal fournissant de ce fait une mesure de la pression.

29. Dispositif selon les revendications 27 et 28, caractérisé par une résistance de référence (122, 124, 126) servant à véhiculer un second courant prédéterminé, ladite résistance de référence étant sensiblement une source de chaleur pour le corps semiconducteur (100) et adaptée pour délivrer un second signal associé à la valeur résistive de la résistance de référence, une relation prédéterminée existant entre la valeur résistive et la température de la résistance de référence, cette température étant sensiblement réglée par la température du corps semiconducteur, ce qui a pour effet que, dans des conditions prédéterminées d'humidité et de pression, respectivement, et de courants, la différence entre les deux signaux possède une valeur prédéterminée.

30. Dispositif selon la revendication 29, caractérisé en ce que la résistance de référence (122, 124, 126) comporte un second élément en permalloy (124); la courbe de variation température-valeur résistive de chaque élément en permalloy (108, 124) est non linéaire la courbe de variation température-valeur résistive de l'élément résistif (108) possède une première pente prédéterminée lors du fonctionnement à la première température prédéterminée; la valeur résistive de la résistance de référence (122, 124, 126) étant établie de telle sorte que, pour une seconde température prédéterminée, la courbe de variation température-valeur résistive de la résistance de référence possède une pente sensiblement égale à la première pente prédéterminée; l'un des éléments résistifs (108) et la résistance de référence (122, 124, 126) comprend une résistance série (126) branchée en série avec l'un des éléments résistif (108) et la résistance de référence (124), la résistance série (126) possédant un coefficient thermique de valeur résistive, sensiblement nul, la valeur résistive totale de la résistance série (124) et de l'un des éléments résistifs (108) et de la résistance de référence (124) étant sensiblement égale, pour la seconde température predéterminée, à la valeur résistive totale de l'autre des éléments résistifs (108) et de la résistance de référence (124), pour la première température predéterminée; ce qui a pour effet que, lorsque les premier et second courants sont sensiblement égaux, les premier et seconds signaux peuvent être décalés de sorte que, respectivement pour une humidité et une pression prédéterminées, la somme des premier et second signaux est sensiblement nulle.

31. Dispositif selon la revendication 30, caractérisé en ce que le corps semiconducteur (100) comporte des moyens de chauffage (12) servant à régler la température du corps semiconducteur à une température prédéterminée.

32. Procédé pour fabriquer un dispositif à semiconducteurs selon l'une des revendications 1 à 31, incluant les étapes suivantes:

a) déposer une couche diélectrique (12, 127, 144) sur ladite première surface (14, 104, 136) dudit corps semiconducteur (10, 100, 132);

b) former au moins un élément électrique statique (16, 108, 142, 150) sur ladite couche diélectrique;

c) mettre à nu au moins une zone prédéterminée (152) de ladite première surface (14, 104, 136) de manière à délimiter chacun des moyens formant capteur (32, 34, 106, 140, 148), l'élément de surface à nu (152) étant délimité en partie par lesdits moyens formant capteur devant être suspendus, lesdits moyens formant capteur étant orientés suivant un angle non nul par rapport à la direction [110] dudit corps en silicium de sorte qu'une corrosion anisotrope appliquée à l'élément de surface à nu (152) crée un évidement sous-jacent au-dessous des moyens formant capteur, en un intervalle de temps sensiblement minimum; et

d) appliquer la corrosion anisotrope à l'élément de surface à nu (152) de manière à former un évidement sous-jacent au-dessous des moyens formant capteur (32, 34, 106, 140, 148) et créer le renfoncement (20, 102, 134).

FIG 1

FIG 2

FIG 3

FIG 4

FIG 5

FIG 6

FIG 7

FIG 9

FIG 8

FIG 10

10,132

60

[110]

FIG 11

10,132

60

[110]

FIG 12

FIG 13